# EUROPÄISCHE PATENTANMELDUNG

(11) **EP 2 007 023 A2**
(43) Veröffentlichungstag der Anmeldung: **24.12.2008**
(21) Anmeldenummer: 08002707.1
(22) Anmeldetag: 14.02.2008
(51) Int. Cl.: H04B 3/54, H04B 3/56

(54) **Installationsgerät**

(30) Priorität: 18.06.2007 DE 102007027926
(71) Anmelder: Insta Elektro GmbH, 58511 Lüdenscheid (DE)
(72) Erfinder: Holtz, Friedhelm, 58511 Lüdenscheid (DE); Piel, Jörg, 58579 Schalksmühle (DE); Wiffel, Peter, 58239 Schwerte (DE)

(57) **Zusammenfassung**

Es wird ein elektrisches/elektronisches Installationsgerät der Gebäudesystemtechnik vorgeschlagen, welches an das Versorgungsnetz eines Gebäudes angeschlossen ist und welches zumindest einen Übertrager aufweist, der jeweils zur Energie- und Informationsübertragung zwischen zwei Schaltungsteilen vorgesehen ist. Zu dem Zweck ein elektrisches/elektronisches Installationsgerät zu schaffen, welches sich nicht nur besonders kostengünstig und einfach herstellen lässt, sondern bei welchem zudem die notwendige Energie- und Informationsübertragung zwischen zumindest zwei potentialgetrennt arbeitenden Schaltungsteilen besonders bauraumsparend realisiert ist, ist zumindest ein zur potenzialgetrennten Energie- und Informationsübertragung vorgesehener Übertrager als ein, eine primärseitige Wicklung und zumindest eine sekundärseitige Wicklung aufweisender, auf einer Leiterkarte angeordneter Lufttrafo ausgebildet.

## Beschreibung

Die vorliegende Erfindung geht von einem gemäß Oberbegriff des Hauptanspruches konzipierten elektrischen/elektronischen Installationsgerät aus.

Derartige elektrische/elektronische Installationsgeräte sind an das Versorgungsnetz eines Gebäudes angeschlossen und z. B. als Bewegungsmelder, als Dimmer, als Helligkeitssensor, als Regensensor, als Mikroschalter, als Jalousieschalter usw. ausgebildet. Möglicherweise stehen solche elektrischen/elektronischen Installationsgeräte auch mit dem Bussystem eines Gebäudes in Verbindung und weisen mehrere Schaltungsteile auf. Dabei sind solche elektrischen/elektronischen Installationsgeräte oftmals mit einem Übertrager in Form eines kernbehafteten Trafos versehen.

Durch die EP 0 365 696 B1 ist ein gemäß Oberbegriff des Hauptanspruch ausgebildetes elektrisches/elektronisches Installationsgerät der Gebäudesystemtechnik bekannt geworden. Ein solches elektrisches/elektronisches Installationsgerät steht mit dem Bussystem des Gebäudes in Verbindung, über welches auch die zur Funktion notwendige Energieversorgung erfolgt. Ein solches elektrisches/elektronisches Installationsgerät weist zumindest einen Übertrager auf, der zur Energie- und Informationsübertragung vorgesehen ist. Ein solcher üblicherweise durch einen kernbehafteten Trafo gebildeter Übertrager benötigt aber nicht nur einen beachtlichen Bauraum, sondern ist zudem bei der Herstellung entsprechend aufwändig und teuer.

Des weiteren ist durch die DE 196 37 580 A1 ein elektrisches/elektronisches Installationsgerät bekannt geworden, welches zwei potentialgetrennte Schaltungsteile aufweist, zwischen denen ein Übertrager angeordnet ist. Der Übertrager dieses elektrischen/elektronischen Installationsgerätes ist jedoch nur zur bidirektionalen Übertragung von Informationen vorgesehen.

Ausgehend von derartig ausgebildeten elektrischen/elektronischen Installationsgeräten liegt der vorliegenden Erfindung die Aufgabe zugrunde, ein elektrisches/elektronisches Installationsgerät zu schaffen, welches sich nicht nur besonders kostengünstig und einfach herstellen lässt, sondern bei welchem zudem die notwendige Energie- und Informationsübertragung zwischen zumindest zwei potentialgetrennt arbeitenden Schaltungsteilen besonders bauraumsparend realisiert ist.

Erfindungsgemäß wird diese Aufgabe durch die im Hauptanspruch angegebenen Merkmale gelöst.

Bei einer solchen Ausbildung ist besonders vorteilhaft, dass sowohl der als Lufttrafo ausgeführte Übertrager mit seinen Wicklungen, als auch zur Funktion notwendige weitere elektronische Bauteile auf einer einzigen Leiterkarte angeordnet sind.

Weitere vorteilhafte Ausgestaltungen des erfindungsgemäßen Gegenstandes sind in den Unteransprüchen angegeben. Anhand von drei Ausführungsbeispielen sei die Erfindung im Prinzip näher erläutert. Dabei zeigt:
- Figur 1:: prinziphaft eine mit einem Lufttrafo und weiteren Bauteilen versehene, drei Isolierlagen aufweisende Leiterkarte in Explosionsdarstellung;
- Figur 2:: prinziphaft eine drei Isolierlagen aufweisende, gemäß Fig. 1 ausgeführte Leiterkarte im Schnitt;
- Figur 3:: prinziphaft ein als Passiv-Infrarot-Bewegungsmelder ausgeführtes ersten Ausführungsbeispiel;
- Figur 4:: prinziphaft ein als Jalousiezeitschaltuhr ausgeführtes zweites Ausführungsbeispiel;
- Figur 5:: prinziphaft ein als Dimmer ausgeführtes drittes Ausführungsbeispiel;

Wie aus den Figuren hervorgeht, weist ein solches an das Versorgungsnetz L, N bzw. Bussystem BUS eines Gebäudes angeschlossenes elektrisches/elektronisches Installationsgerät zumindest einen Übertrager auf, der jeweils zur potenzialgetrennten Energie- und Informationsübertragung zwischen einem ersten Schaltungsteil A und einem zweiten Schaltungsteil B angeordnet ist. Ein solcher zur potenzialgetrennten Energie- und Informationsübertragung vorgesehener Übertrager ist in vorliegendem Fall als ein, eine primärseitige Wicklung 1 und zumindest eine sekundärseitige Wicklung 2 aufweisender Lufttrafo 3 ausgebildet.

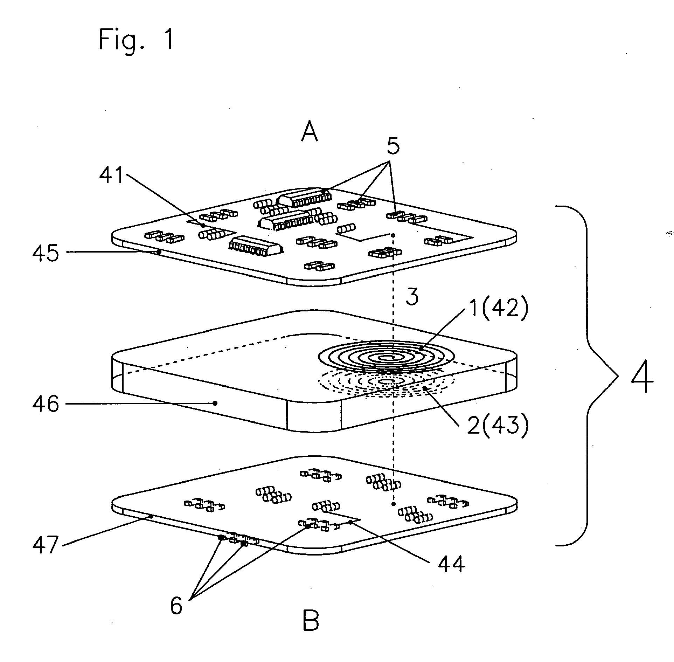

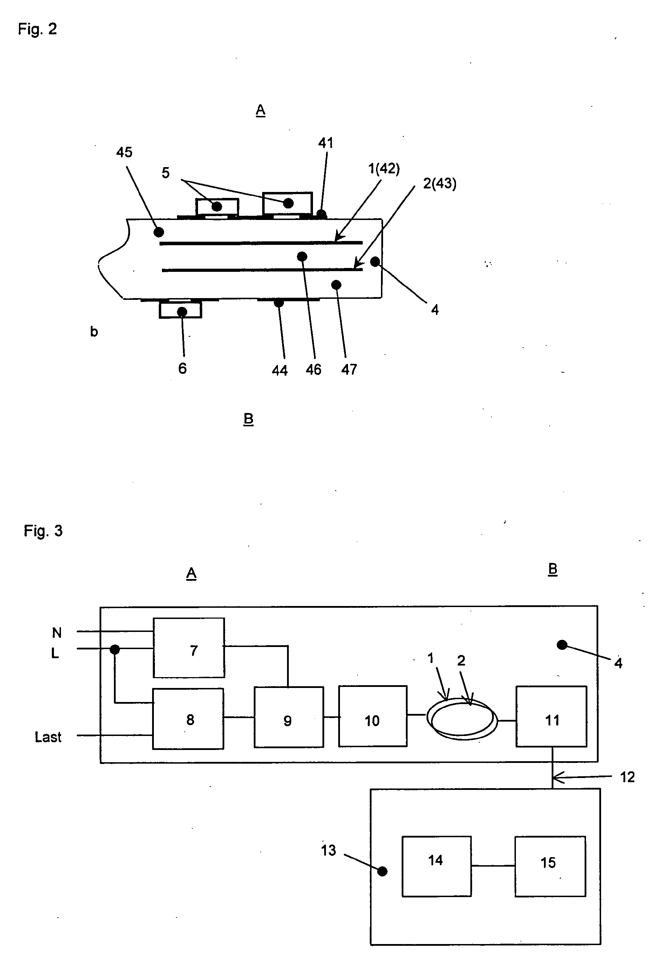

Wie des weiteren insbesondere aus Fig. 1 und Fig. 2 hervorgeht, weist die den Lufttrafo 3 aufweisende Leiterkarte 4 vier elektrische Leiterplattenlagen 41, 42, 43, 44 auf, welche auf drei Isolierlagen 45, 46, 47 aufgebracht sind. Die primärseitige Wicklung 1 und die sekundärseitige Wicklung 2 des als Lufttrafo 3 ausgebildeten Übertrager sind auf die beiden Hauptflächen der mittleren Isolierlage 46 der Leiterkarte 4 aufgebracht und stellen den wesentlichen Teil der beiden inneren elektrischen Leiterplattenlagen 42, 43 der Leiterkarte 4 dar. Die obere Isolierlage 45 weist auf ihrer äußeren Hauptfläche eine obere elektrische Leiterplattenlage 41 auf, die unter anderem mit mehreren Leiterbahnen versehen und mit weiteren ersten elektronischen Bauteilen 5 bestückt ist. Die untere Isolierlage 47 weist auf ihrer äußeren Hauptfläche eine untere elektrische Leiterplattenlage 44 auf, die unter anderem ebenfalls mit mehreren Leiterbahnen und mit weiteren zweiten Bauteilen 6 bestückt ist. Die weiteren ersten Bauteile 5 und die weiteren zweiten Bauteile 6 sind zur Funktion des elektrischen/elektronischen Installationsgerätes bzw. des Lufttrafos 3 notwendig, wobei die weiteren ersten Bauteile 5 dem ersten Schaltungsteil A und die weiteren zweiten Bauteile 6 dem zweiten Schaltungsteil B zugeordnet sind. Der Lufttrafo 3 sorgt somit bei sehr geringem Platzbedarf für eine besonders funktionssichere Energie- und Informationsübertragung zwischen den beiden potenzialgetrennten Schaltungsteilen A, B.

Als Lufttrafo 3 wird im vorliegenden Fall eine Anordnung bezeichnet, die als kernloser Trafo in eine Leiterkarte integriert ist.

Wie zudem insbesondere aus Fig. 1 und Fig. 2 hervorgeht, sind die weiteren ersten Bauteile 5 auf der gesamten oberen elektrischen Leiterplattenlage 41, insbesondere auch direkt über der primärseitigen Wicklung 1 auf der Leiterkarte 4 angeordnet. Auch sind die weiteren zweiten Bauteile 6 auf der gesamten unteren elektrischen Leiterplattenlage 44, insbesondere auch direkt über der sekundärseitigen Wicklung 2 auf der Leiterkarte 4 angeordnet. Eine solche Anordnung sorgt für einen guten Ausnutzungsgrad der Leiterkarte 4, wodurch die Herstellung von besonders kompakt ausgeführten elektrischen/elektronischen Installationsgeräten möglich ist.

Wie insbesondere aus Fig. 3 hervorgeht, ist ein solches elektrisches/elektronisches Installationsgerät in einem ersten Ausführungsbeispiel als Passiv-Infrarot-Bewegungsmelder ausgeführt. Der Passiv-Infrarot-Bewegungsmelder weist eine an das Versorgungsnetz L, N des Gebäudes angeschlossene Leiterkarte 4 auf, die mit einer Stromversorgung 7, einem Lastrelais 8, einem zur Steuerung vorgesehenen Mikrocontroller 9 und einem als Lufttrafo 3 ausgebildeten Übertrager versehen ist. Die erste Beschaltung 10 der primärseitigen Wicklung 1 und die zweite Beschaltung 11 der sekundärseitigen Wicklung 2 des Lufttrafo 3 stehen über eine SELV-Leitungsverbindung 12 mit einer weiteren Leiterkarte 13 in Verbindung, auf der eine Passiv-Infrarot-Sensoranordnung 14, sowie eine sekundärseitige Versorgungs- und Sendestufe 15 angeordnet sind. Ein solcher Passiv-Infrarot-Bewegungsmelder ist insbesondere für den Einbau in Möbel oder Leuchten vorgesehen. Die galvanische Trennung ist auf platzsparende und kostengünstige Art und Weise durch den Lufttrafo 3 realisiert.

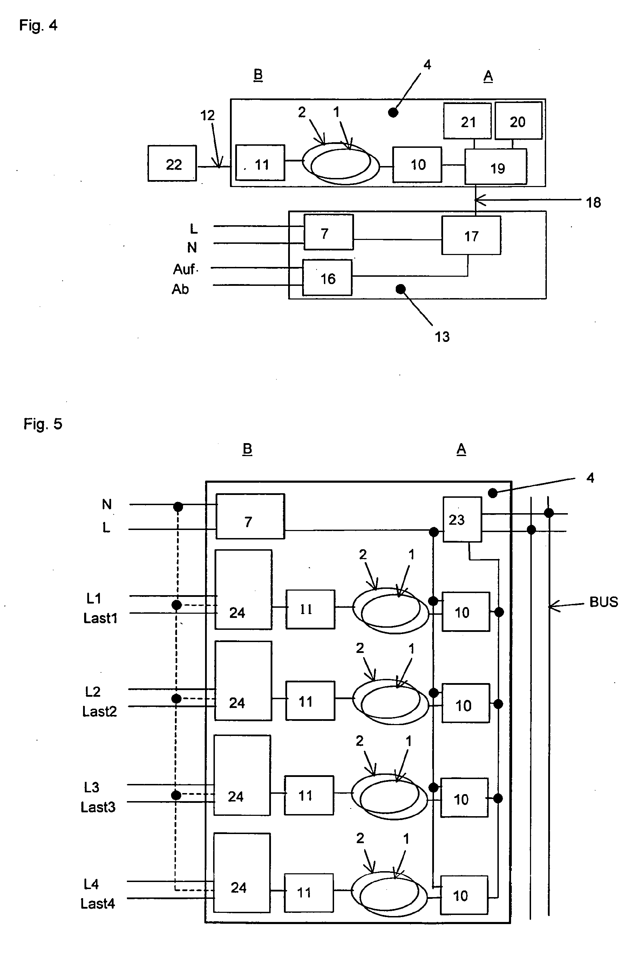

Wie insbesondere aus Fig. 4 hervorgeht, ist ein solches elektrisches/elektronisches Installationsgerät in einem zweiten Ausführungsbeispiel als Jalousiezeitschaltuhr ausgeführt. Es ist eine weitere Leiterkarte 13 vorgesehen, die über eine Stromversorgung 7 an das Versorgungsnetz L, N des Gebäudes angeschlossen ist und eine Lastschaltanordnung 16 aufweist. Über eine elektrische Ansteuer- und Auswertelogik 17 und eine Einsatz-Aufsatz-Schnittstelle 18 steht die einem Unterputzeinsatz zugehörige weitere Leiterkarte 13 mit einer, einem Aufsatz zugehörige Leiterkarte 4 in Verbindung. Die Leiterkarte 4 ist mit einer elektronischen Ansteuer- und Auswertestufe 19, einem Display 20, einem Tastenfeld 21 und einem als Lufttrafo 3 ausgebildeten Übertrager versehen. Der Lufttrafo 3 weist eine erste Beschaltung 10 für seine primärseitige Wicklung 1 und eine zweite Beschaltung 11 für seine sekundärseitige Wicklung 2 auf, wobei die sekundärseitige Wicklung 2 über eine SELV-Leitungsverbindung 12 mit einem Helligkeitssensor 22 in Verbindung steht. Somit ist die galvanische Trennung zwischen Sensorik und Aktorik besonders kompakt bauend und kostengünstig realisiert.

Wie insbesondere aus Fig. 5 hervorgeht, ist ein solches elektrisches/elektronisches Installationsgerät in einem dritten Ausführungsbeispiel als Dimmer ausgeführt. Der Dimmer weist eine, einerseits über eine galvanisch getrennte Stromversorgung 7 an das Versorgungsnetz L, N und andererseits über eine Busansteuerung 23 an ein Bussystem BUS des Gebäudes angeschlossene Leiterkarte 4 auf. Auf der Leiterkarte 4 sind vier unabhängig voneinander arbeitende Dimmkanäle 24 angeordnet, die auf unterschiedlichen Phasen L 1, L 2, L 3 des Versorgungsnetzes L, N verteilt werden können, wobei jedem der vier Dimmkanäle 24 jeweils ein für die Energie- und bidirektionale Informationsübertragung vorgesehener, als Lufttrafo 3 ausgebildeter Übertrager zugeordnet ist. Die erste Beschaltung 10 für die primärseitige Wicklung 1 eines jeden Lufttrafo 3 steht jeweils über eine Busansteuerung 23 mit dem Bussystem BUS des Gebäudes in Verbindung. Die zweite Beschaltung 11 für die sekundärseitige Wicklung 2 eines jeden Lufttrafo 3 steht hingegen jeweils mit einem der vier Dimmkanäle 24 in Verbindung. Somit ist die galvanische Trennung zwischen dem Bussystem BUS und den vier Dimmkanälen 24 besonders kompakt bauend und kostengünstig realisiert.

## Patentansprüche

1. Elektrisches/elektronisches Installationsgerät der Gebäudesystemtechnik, welches an das Versorgungsnetz eines Gebäudes angeschlossen ist, und welches zumindest einen Übertrager aufweist, der jeweils zur Energie- und Informationsübertragung zwischen zwei Schaltungsteilen vorgesehen ist, **dadurch gekennzeichnet, dass** zumindest ein zur potentialgetrennten Energie- und Informationsübertragung vorgesehener Übertrager als ein, eine primärseitige Wicklung (1) und zumindest eine sekundärseitige Wicklung (2) aufweisender, auf einer Leiterkarte (4) angeordneter Lufttrafo (3) ausgebildet ist.

2. Elektrisches/elektronisches Installationsgerät nach Anspruch 1, **dadurch gekennzeichnet, dass** die erste Beschaltung der primärseitigen Wicklung (1) zumindest eines als Lufttrafo (3) ausgebildeten Übertragers einen mit Resonanzüberhöhung arbeitenden Oszillator aufinreist.

3. Elektrisches/elektronisches Installationsgerät nach Anspruch 1 oder 2, **dadurch gekennzeichnet, dass** die Informationsübertragung von der sekundärseitigen Wicklung (2) zur primärseitigen Wicklung (1) zumindest eines als Lufttrafo (3) ausgebildeten Übertragers durch Dämpfung der Sekundärspannung durch Zuschaltung einer zweiten Beschaltung mit niedriger Impedanz erfolgt.

4. Elektrisches/elektronisches Installationsgerät nach einem der Ansprüche 1 bis 3, **dadurch gekennzeichnet, dass** die Informationsübertragung von der primärseitigen Wicklung (1) zur sekundärseitigen Wicklung (2) zumindest eines als Lufttrafo (3) ausgebildeten Übertragers durch Veränderung der primärseitigen Wechselspannung erfolgt.

5. Elektrisches/elektronisches Installationsgerät nach einem der Ansprüche 1 bis 4, **dadurch gekennzeichnet, dass** die primärseitige Wicklung (1) und zumindest eine sekundärseitige Wicklung (2) zumindest eines als Lufttrafo (3) ausgebildeten Übertragers auf einer einzigen, zumindest zwei elektrische Leiterplattenlagen (41, 44) aufweisenden Leiterkarte (4) angeordnet sind.

6. Elektrisches/elektronisches Installationsgerät nach einem der Ansprüche 1 bis 4, **dadurch gekennzeichnet, dass** die primärseitige Wicklung (1) und zumindest eine sekundärseitige Wicklung (2) zumindest eines als Lufttrafo (3) ausgebildeten Übertragers auf den beiden inneren elektrischen Leiterplattenlagen (42, 43) einer zumindest vier elektrische Leiterplattenlagen (41, 42, 43, 44) aufweisenden Leiterkarte (4) angeordnet sind.

7. Elektrisches/elektronisches Installationsgerät nach einem der Ansprüche 1 bis 6, **dadurch gekennzeichnet, dass** die gesamte Hauptfläche einer außenliegenden oberen elektrischen Leiterplattenlage (41) und/oder die gesamte Hauptfläche einer außenliegenden unteren elektrischen Leiterplattenlage (44) einer Leiterkarte (4) zur Bestückung mit weiteren ersten Bauteilen (5) und/oder weiteren zweiten Bauteilen (6) vorgesehen ist.

8. Elektrisches/elektronisches Installationsgerät nach einem der Ansprüche 1 bis 7, **dadurch gekennzeichnet, dass** die auf Netzpotenzial des Versorgungsnetzes (L, N) des Gebäudes arbeitenden weiteren ersten Bauteile (5) zumindest eines ersten Schaltungsteils (A) auf einer elektrische Leiterbahnen aufweisenden oberen elektrischen Leiterplattenlage (41), und dass die weiteren zweiten Bauteile (6) zumindest eines vom ersten Schaltungsteil (A) potentialgetrennten zweiten Schaltungsteils (B) auf einer elektrische Leiterbahnen aufweisenden unteren elektrischen Leiterplattenlage (44) der Leiterkarte (4) platziert sind.

9. Elektrisches/elektronisches Installationsgerät nach einem der Ansprüche 1 bis 8, **dadurch gekennzeichnet, dass** zumindest ein Teil der weiteren ersten Bauteile (5) und/oder weiteren zweiten Bauteile (6) zumindest teilweise innerhalb einer der Leiterplattenlagen (41,42,43,44) platziert sind.

10. Elektrisches/elektronisches Installationsgerät nach einem der Ansprüche 1 bis 9, **dadurch gekennzeichnet, dass** dieses als Passiv-Infrarot-Bewegungsmelder ausgeführt ist und eine an das Versorgungsnetz (L, N) des Gebäudes angeschlossene Leiterkarte (4) aufweist, die mit einer Stromversorgung (7), einem Lastrelais (8), einem zur Steuerung vorgesehenen Mikrocontroller (9) und einem als Lufttrafo (3) ausgebildeten Übertrager versehen ist, und dass die erste Beschaltung (10) der primärseitigen Wicklung (1) und die zweite Beschaltung (11) der sekundärseitigen Wicklung (2) über eine SELV-Leitungsverbindung (12) mit einer weiteren Leiterkarte (13) in Verbindung steht, auf der eine Passiv-Infrarot-Sensoranordnung (14), sowie eine sekundärseitige Versorgungs- und Sendestufe (15) angeordnet sind.

11. Elektrisches/elektronisches Installationsgerät nach einem der Ansprüche 1 bis 9, **dadurch gekennzeichnet, dass** dieses als Jalousiezeitschaltuhr ausgeführt ist und eine, über eine Stromversorgung (7) an das Versorgungsnetz (L, N) des Gebäudes angeschlossene, mit einer Lastschaltanordnung (16) versehene, einem Einsatz zugehörige Leiterkarte (13) aufweist, die über eine elektrische Ansteuer- und Auswertelogik (17) und eine Einsatz-Aufsatz-Schnittstelle (18) mit einer, einem Aufsatz zugehörigen Leiterkarte (4) in Verbindung steht, und dass die Leiterkarte (4) mit einer elektronischen Ansteuer- und Auswertestufe (19), einem Display (20), einem Tastenfeld (21) und einem als Lufttrafo (3) ausgebildeten Übertrager versehen ist, und dass der Lufttrafo (3) eine erste Beschaltung (10) für seine primärseitige Wicklung (1) und eine zweite Beschaltung (11) für seine sekundärseitige Wicklung (2) aufweist, und dass die sekundärseitige Wicklung (2) über eine SELV-Leitungsverbindung (12) mit einem Helligkeitssensor (22) in Verbindung steht.

12. Elektrisches/elektronisches Installationsgerät nach einem der Ansprüche 1 bis 9, **dadurch gekennzeichnet, dass** dieses als Dimmer ausgeführt ist und eine einerseits über eine Stromversorgung (7) an das Versorgungsnetz (L, N) und andererseits über eine Bussteuerung (23) an ein Bussystem (BUS) des Gebäudes angeschlossene Leiterkarte (4) aufweist, und dass auf der Leiterkarte (4) mehrere unabhängig voneinander arbeitende Dimmkanäle (24) vorhanden sind, und dass jedem der Dimmkanäle (24) ein für die Energie- und bidirektionale Informationsübertragung vorgesehener, als Lufttrafo (3) ausgebildeter Übertrager zugeordnet ist, und dass die erste Beschaltung (10) für die primärseitige Wicklung (1) eines jeden Lufttrafos (3) jeweils über die Busansteuerung (23) mit dem Bussystem (BUS) des Gebäudes in Verbindung steht, und dass die zweite Beschaltung (11) für die sekundärseitige Wicklung (2) eines jeden Lufttrafos (3) jeweils mit einem der Dimmkanäle (24) in Verbindung steht.

13. Elektrisches/elektronisches Installationsgerät nach einem der Ansprüche 1 bis 9, **dadurch gekennzeichnet, dass** dieses als kapazitiver Näherungsschalter ausgeführt ist, und dass die primärseitige Wicklung (1) des Lufttrafos (3) mit dem Versorgungsnetz (L, N), und dass die sekundärseitige Wicklung (2) des Lufttrafos (3) mit einer kapazitiven Messeinrichtung in Verbindung steht.

14. Elektrisches/elektronisches Installationsgerät nach einem der Ansprüche 1 bis 9, **dadurch gekennzeichnet, dass** dies als beleuchtbarer Mikroschalter ausgeführt ist, und dass die primärseitige Wicklung (1) des Lufttrafos (3) mit dem Versorgungsnetz (L, N), und dass die sekundärseitige Wicklung (2) des Lufttrafos (3) mit einer Anzeige- und Bedieneinrichtung in Verbindung steht.

15. Elektrisches/elektronisches Installationsgerät nach einem der Ansprüche 1 bis 9, **dadurch gekennzeichnet, dass** dieses als Regensensor ausgeführt ist, und dass die primärseitige Wicklung (1) des Lufttrafos (3) mit dem Versorgungsnetz (L, N), und dass die sekundärseitige Wicklung (2) des Lufttrafos (3) mit einer Messeinrichtung in Verbindung steht.
